# EUROPEAN PATENT SPECIFICATION

(11) **EP 1 233 664 B1**
(45) Date of publication and mention of the grant of the patent: **11.01.2006**
(21) Application number: 02006757.5
(22) Date of filing: 06.09.1999
(51) Int. Cl.: H05K 5/02, H04B 1/38

(54) **Rechargeable battery powered portable heavy duty audio equipment**
Nachladbare Batterie angetriebenes tragbares zwangsbeständige Audiogerät
Dispositif audiophonique portatif actionné par pile rechargeable et résistant aux contraintes

(30) Priority: 15.09.1998 US 153621; 04.03.1999 US 262751
(43) Date of publication of application: 21.08.2002
(62) Divisional of application: 99307059.8
(73) Proprietor: Black & Decker Inc., Newark, DE 19711 (US)
(72) Inventor: Smith, Roger Q., Reisterstown, Maryland 21136 (US)
(74) Representative: Bell, Ian Stephen

(56) References cited:
- WO-A-97/43921

## Description

This invention relates generally to audio equipment and, more particularly, to heavy-duty radios.

It is well known that audio equipment, such as portable radios, are taken to construction sites, so that the construction workers can listen to music, talk shows, etc., while working. However, the audio equipment may be destroyed at the jobsite because tools may be dropped on them. Similarly, the equipment may fall from a table, etc., resulting in damage thereto.

It is therefore an object of this invention to provide an audio equipment that can withstand the rigors of a jobsite.

Furthermore, because construction workers have different cordless power tools, it would be beneficial if the audio equipment would receive the rechargeable battery packs used with the power tools in order to charge the battery packs and/or power the audio equipment.

In accordance with the present invention, an improved audio equipment is employed. The audio equipment includes a housing, audio circuitry installed within the housing, and at least one protective covering, shell or bar flexibly connected to the housing. Preferably, a handle may be attached to the protective covering.

Additional features and benefits of the present invention are described, and will be apparent from, the accompanying drawings and the detailed description below.

The accompanying drawings illustrate preferred embodiments of the invention according to the practical application of the principles thereof, and in which:
FIG. 1 is a front elevational of an audio equipment according to the present invention;
FIG. 2 is a rear elevational view of the audio equipment of FIG. 1;
FIG. 3 is a side elevational view of the audio equipment of FIG. 1;
FIG. 4 is a cross-sectional view along line IV-IV of FIG. 3;
FIG. 5 is a block diagram of the circuitry of the audio equipment of FIG. 1; and
FIG. 6 is a cross-sectional view along line VI-VI of FIG. 2.

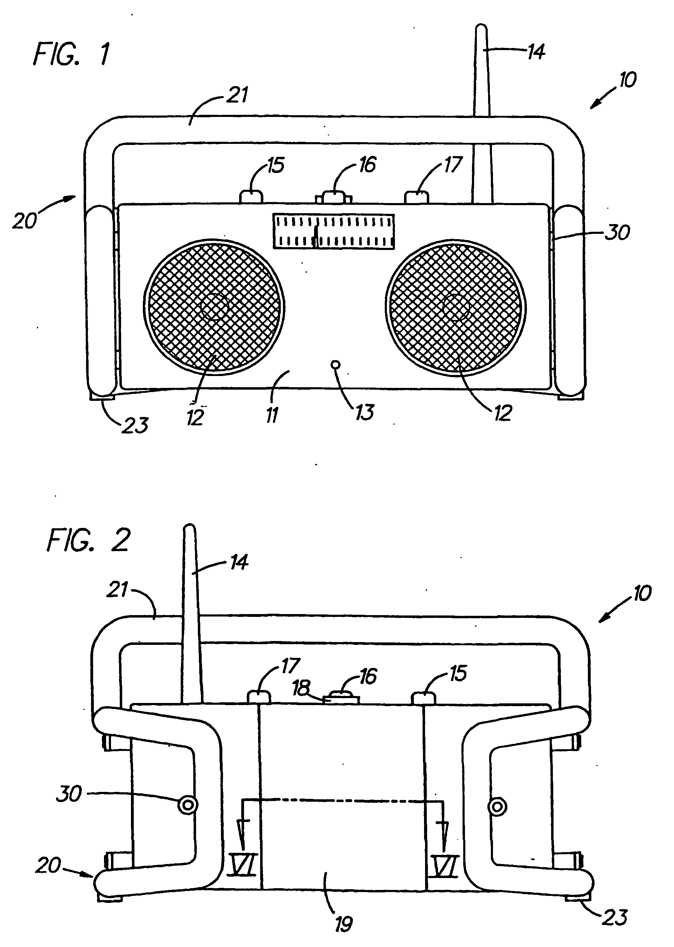

The invention is now described with reference to the accompanying figures, wherein like numerals designate like parts. Referring to FIGS. 1-3, an audio equipment component, such as radio 10, of the present invention comprises a housing 11. Housing 11 may support the radio circuitry (not shown), the speakers 12 connected to the radio circuitry, the volume, tuning and switch knobs (15, 16 and 17 respectively), antenna 14, and auxiliary input jack 13.

Preferably speakers 12 and part of housing 11 are coated with a waterproof coating, such as a rubber coating or paint. Alternatively, other waterproofing schemes may be used for protecting the speakers 12. For example, US Patent Nos. 3,391,754, 2,829,728, and 2,517,138 disclose appropriate waterproofing schemes and are hereby incorporated by reference.

The knobs may also comprise waterproofing means for impeding entry of water into housing 11. Such means may include walls created on the housing 11 and/or the knobs, creating a labyrinth passage for water. Alternatively, other waterproofing schemes may be used for the knobs. For example, US Patent Nos. 3,391,754, 3,277,739, 2,502,915 and 1,162,793 disclose appropriate waterproofing schemes and are hereby incorporated by reference.

Antenna 14 is preferably constructed of a flexible material, allowing antenna 14 to bend without breaking.

Preferably, at least one protective covering, shield, or shell is flexibly connected to the housing 11. An example of this protective covering is protective bar 20. Such covering or shield, e.g., bar 20, may be made of aluminum, or other suitable material. Preferably, covering or shield, e.g., bar 20 is made of a plastic, such as ABS or polypropylene. The covering or shield, e.g., bar 20, may be injection-molded. Alternatively, when the covering or shield is shaped as a bar, the plastic may be injected into a mold (preferably about half the volume needed to complete fill the mold and thus filling half of the mold), then air or gas is blown therein, pushing the plastic into the other half of the mold, forming a hollow tube. This process is known as gas-assist injection molding.

Preferably, the protective covering or shield is comprised of two bars 20 which are formed in respective loops and are connected to a respective side of housing 11. The protective covering or shield may also include a handle 21, which may be fixedly attached to the bars 20 via, e.g., screws (not shown). Preferably, the shape of bars 20 and/or handle 21 is such that the housing 11 cannot be contacted by anything wider than the handle 21 and/or bars 20. Such construction minimizes the risk of damage to housing 11, but still allows access to the working components of the radio and/or does not muffle the sound produced by the speakers.

Persons skilled in the art will recognize that the protective shield or bar 20 are preferably are releasably attached to the housing by coacting fasteners, such as screws, bolts, etc. By adapting protective shield or bar 20 in this manner, a user can replace parts of the protective shield or one bar 20 when damaged without incurring the expense of replacing entire shield, all bars 20 or radio 10.

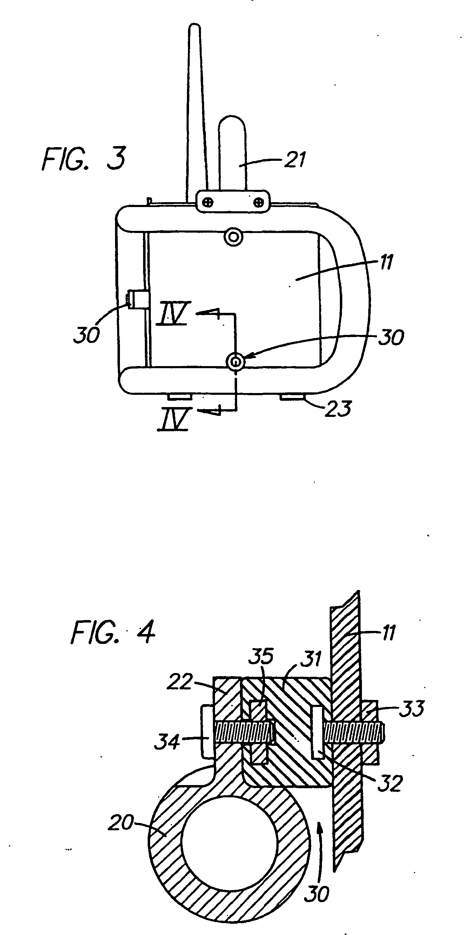

As mentioned above, the protective shield or bars 20 may be flexibly connected to the housing. Such connection is achieved via the connector assemblies 30. Referring to FIG. 4, a connector assembly 30 is disposed between the bar 20 and housing 11. The connector assembly 30 comprises a flexible gasket 31, which is preferably made of a flexible, resilient material such as rubber or an elastometer. The gasket 31 may be connected to the bar 20 via a screw 34 threadedly engaging a nut 35. The gasket 31 in turn may be connected to the housing 11 via a screw 32 threadedly engaging a nut 33. Gasket 31 may be molded over screw 32 and/or nut 35. Such construction minimizes the shock received by housing 11, and thus by the circuitry mounted within, when radio 10 is dropped.

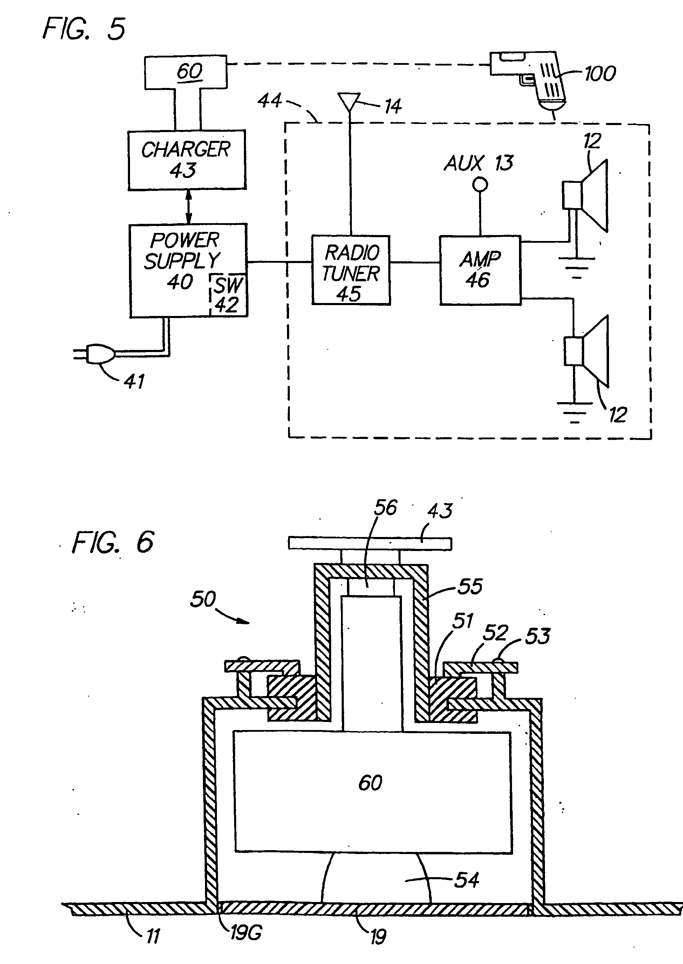

Referring to FIGS. 2 and 6, housing 11 may also have a door 19 pivotally attached thereto, providing access to receptacle assembly 50 and allowing an operator to install a battery pack 60 within housing 11. The door 19 may be kept in a closed position by latch 18. Preferably, latch 18 comprises an overcenter mechanism.

Door 19 may have a gasket 19G disposed thereon to limit the ingress of water into, if not wholly waterproof, receptacle assembly 50. Preferably gasket 19G is made of rubber or an elastomeric material. Persons skilled in the art will recognize that the gasket 19G may be disposed on housing 11 and perform the same function.

Preferably, receptacle assembly 50 is designed to receive a battery pack 60 via a connector 56. The connector 56 has a configuration appropriate to contact the battery terminals. Preferably the battery pack terminals and connector 56 will be arranged in the manner disclosed in U.S. Patent No. 5,144,217, which is hereby incorporated in whole by reference.

The charger circuitry 43 may be fixedly connected to both connector 56 and receptacle assembly 50. Connector 56 is preferably disposed on a floating receptacle housing 55, to minimize the shock received by the battery pack 60 and the circuitry 43 if the radio 10 is dropped. Charger circuitry 43 allows charging of battery packs having different voltages, as is well known in the art.

The receptacle housing 55 may be flexibly connected to the housing 11 via a flexible gasket 51. Preferably, gasket 51 is generally annular and made of a flexible, resilient material, such as rubber or elastometer.

Retainers 52 may be installed on housing 11 to prevent the disengagement of gasket 51 and housing 11 when pushing the battery pack 60 in place. Retainers 52 may be attached to housing 11 via screws 53 and may have a generally annular form. Retainers 52 may also prevent the removal of receptacle housing 55 when removing the battery pack 60 by providing a stopping surface which would contact the charger circuitry board 43.

A spring 54 may also be provided on door 19 to bias battery pack 60 into connection with connector 56. Preferably spring 54 will be flexible enough to bias battery packs having different sizes.

FIG. 5 is a block diagram of the circuitry within housing 11. Charger circuitry 43 is connected to a power supply 40. Power supply 40 may receive power from an alternating current source via connector 41 and/or from charger 43 when a battery pack is being used as the power source for the radio 10. In addition, power supply 40 provides power to charger 43 in order to charge battery pack 60 even while the radio 10 is in operation.

Power supply 40 also provides power to radio circuitry 44. A switching means 42 may be connected to switch knob 17 to properly select the components receiving power. For example, the user can select if the power supply 40: (a) provides power to both the radio circuitry 44 and to charger 43 (for charging battery pack 60); (b) provides power to the radio circuitry 44 from the battery pack 60; (c) provides no power to any component; etc. Switching means 42 may comprise relays, transistors or other switching devices as is well known in the art. Preferably power supply 40 can accept power from battery packs having different voltages.

Radio circuitry 44 may comprise three main modules: (a) radio tuner 45 for receiving and demodulating the radio signal received via antenna 14; (b) amplifier 46 connected to tuner 45 for amplifying the demodulated radio signal; and (c) speakers 12 connected to amplifier 46 for converting the amplified signal into audible signals. Amplifier 46 may also amplify signals received from an auxiliary input 13, allowing a user to play a separate cassette deck or compact disk player through the radio 10.

Persons skilled in the art should recognize that the specific circuitry for each component is well known in the art. For example, radio circuitry 44 may include an FM Front End integrated circuit, such as the Sanyo LA1186N used in a well-known manner, in combination with a low frequency power amplifier integrated circuit, such as the Toshiba TA8227P used in a well-known manner. Persons skilled in the art are referred to the specifications of these two integrated circuits for further information on the standard usage, capabilities, parameters, etc.

Moreover, the radio circuitry 44 may be replaced with other circuitry for producing audio signals to the speakers via circuitry used with a cassette deck, compact disk or other methods to play music.

Preferably charger 43 is shielded with a metal covering, such as lead, copper, gold, etc., so as to not affect the reception, processing and/or amplification of the radio signal. Similarly, charger 43 can be provided with induction coils, or other types of filters, so as to minimize the effect of the charger on the radio signal, etc.

With such construction, for example, a user can charge a battery pack by disposing the battery pack 60 in the charger 43, providing power to the battery pack 60, and removing the battery pack 60 from the charger 43. The battery pack 60 can then be inserted into a power tool, such as drill 100 (FIG. 5). In other words, the user can listen to the radio 10 while charging the battery pack 60. Alternatively, the user can manually switch the power supply 40 so that the radio circuitry 43 receives the operating power from the battery pack 60, rather than from the alternating current source.

Persons skilled in the art may recognize other alternatives to the means disclosed herein. However, all these additions and/or alterations are considered to be equivalents of the present invention.

## Claims

1. Audio equipment comprising:
a housing (11); and
audio circuitry (44) installed within the housing;
**characterised in that** a protective shield (20) is flexibly connected to the housing.

2. Audio equipment according to claim 1 wherein the protective shield is in the form of a bar (20).

3. Audio equipment according to claim 1 or claim 2 further comprising a handle (21) attached to the protective shield.

4. Audio equipment according to any one of claims 1 to 3, further comprising a connector assembly (30), which flexibly connects the protective shield to the housing.

5. Audio equipment according to claim 4 wherein the connector assembly comprises a flexible gasket (31).

6. Audio equipment according to claim 4 or claim 5 wherein the connector assembly is disposed between the protective shield and the housing.

7. Audio equipment according to any one of claims 1 to 6, further comprising a second protective shield flexibly connected to the housing.

8. Audio equipment according to claim 7 wherein the protective shields are comprised of two bars (20) which are formed in respective loops and are connected to a respective side of the housing.

9. Audio equipment according to claim 8 having a protective shield further comprising a handle (21), which is fixedly attached to the bars (20).

10. Audio equipment according to any one of the preceding claims further comprising:
a power supply (40);
a battery pack charger (43) connected to the power supply;
a circuit (44) for producing an audio signal, preferably a radio circuit, connected to the power supply; and
a battery pack (60) for use with a power tool, the battery pack removably connected to the battery pack charger for charging.

11. Audio equipment according to any one of the preceding claims additionally comprising a receptacle assembly (50) for receiving a battery flexibly connected to the main housing.

12. Audio equipment according to claim 11, wherein the receptacle assembly comprises a receptacle housing (55) and a flexible gasket (51), preferably made of rubber or elastomer is disposed between the receptacle housing and the main housing.

13. Audio equipment according to claim 12 wherein the receptacle assembly further comprises at least one retainer (52) disposed on the housing to prevent disengagement of the gasket.

14. Audio equipment according to any one of claims 11 to 13, further comprising a door (19) hingably connected to the main housing and opposite of the receptacle assembly.

15. Audio equipment according to claim 14, wherein the door has a spring (54) disposed thereon to bias a battery disposed in the receptacle assembly towards a connecting position.

16. Audio equipment according to any one of the preceding claims wherein the audio circuit is a radio circuit.

17. Audio equipment according to any one of the preceding claims, comprising:
a charger (43) disposed within the housing;
a receptacle (50) in the charger;
a battery pack (60) detachably connectable in a power tool mounted in the receptacle;
a first electrical circuit in the charger for charging the battery pack and for powering the audio circuit; and
a connector for connecting the first electrical circuit to a power source.

18. Audio equipment according to claim 17 wherein the connector is adapted for connection to an AC power source, and the equipment further comprises a second electrical circuit connectable to the battery pack for powering the audio circuitry when the connector is disconnected from an AC power source.

19. A method of manufacturing audio equipment as claimed in any one of the preceding claims, comprising:
making a housing (11);
providing a first protective shield (20);
flexibly connecting the first protective shield to the housing.

## Patentansprüche

1. Audiogerät mit
einem Gehäuse (11) und
einer im Gehäuse vorgesehenen Audioschaltung (44),
**dadurch gekennzeichnet, dass** ein Schutzschild (20) elastisch mit dem Gehäuse verbunden ist.

2. Audiogerät nach Anspruch 1, bei dem das Schutzschild die Form einer Stange (20) hat.

3. Audiogerät nach Anspruch 1 oder 2, ferner aufweisend einen am Schutzschild angebrachten Griff (21).

4. Audiogerät nach einem der Ansprüche 1 bis 3, ferner aufweisend eine Verbindungsanordnung (30), die das Schutzschild elastisch mit dem Gehäuse verbindet.

5. Audiogerät nach Anspruch 4, bei dem die Verbindungsanordnung eine elastische Manschette (31) aufweist.

6. Audiogerät nach Anspruch 4 oder 5, bei dem die Verbindungsanordnung sich zwischen Schutzschild und Gehäuse befindet.

7. Audiogerät nach einem der Ansprüche 1 bis 6, ferner aufweisend ein zweites, elastisch mit dem Gehäuse verbundenes Schutzschild.

8. Audiogerät nach Anspruch 7, bei dem die Schutzschilder zwei Stangen (20) aufweisen, die jeweils zu Schlaufen geformt und mit einer jeweiligen Seite des Gehäuses verbunden sind.

9. Audiogerät nach Anspruch 8 mit einem Schutzschild, das ferner einen fest an den Stangen (20) angebrachten Griff (21) aufweist.

10. Audiogerät nach einem der vorhergehenden Ansprüche, ferner aufweisend:
eine Stromversorgung (40),
eine mit der Stromversorgung verbundene Batterieeinheit-Ladeanvrdnung (43),
eine mit der Stromversorgung verbundene Schaltung (44) zur Erzeugung von Tonsignalen, vorzugsweise eine Rundfunkschaltung, und
eine mit einem angetriebenen Werkzeug verwendbare Batterieeinheit (60), die zum Aufladen lösbar mit der Batterieeinheit-Ladeanordnung verbunden ist.

11. Audiogerät nach einem der vorhergehenden Ansprüche, zusätzlich enthaltend eine Aufnahmeanordnung (50) zur Aufnahme einer elastisch mit dem Hauptgehäuse verbundenen Batterie.

12. Audiogerät nach Anspruch 11, bei dem die Aufnahmeanordnung ein Aufnahmegehäuse (55) und zwischen dem Aufnahmegehäuse und dem Hauptgehäuse eine elastische Manschette (51) aufweist, die vorzugsweise aus Gummi oder einem Elastomeren hergestellt ist.

13. Audiogerät nach Anspruch 12, bei dem die Aufnahmeanordnung ferner mindestens einen am Gehäuse vorgesehenen Halter (52) zum Verhindern des Lösens der Manschette aufweist.

14. Audiogerät nach einem der Ansprüche 11 bis 13, ferner aufweisend eine scharnierartig mit dem Hauptgehäuse verbundene und gegenüber der Aufnahmeanordnung vorgesehene Klappe (19).

15. Audiogerät nach Anspruch 14, bei dem die Klappe eine an ihr vorgesehene Feder (54) zum Vorspannen einer in der Aufnahmeanordnung befindlichen Batterie in Richtung auf die Verbindungsstellung hat.

16. Audiogerät nach einem der vorhergehenden Ansprüche, bei dem die Audioschaltung eine Rundfunkschaltung ist.

17. Audiogerät nach einem der vorhergehenden Ansprüche mit
einer im Gehäuse vorgesehenen Ladeanordnung (43),
einer Aufnahme (50) in der Ladeanordnung,
einer in der Aufnahme befestigten, lösbar mit einem angetriebenen Werkzeug verbindbaren Batterieeinheit (60),
einer ersten elektrischen Schaltung in der Ladeanordnung zum Aufladen der Batterieeinheit und zum Speisen der Audioschaltung und
einem Verbinder zum Verbinden der ersten elektrischen Schaltung mit einer Spannungsquelle.

18. Audiogerät nach Anspruch 17, bei dem der Verbinder zur Verbindung mit einer Wechselspannungsquelle angepasst ist und das Gerät ferner eine zweite elektrische Schaltung aufweist, die zum Speisen der Audioschaltung mit der Batterieeinheit verbindbar ist, wenn der Verbinder von einer Wechselspannungsquelle getrennt ist.

19. Verfahren zur Herstellung eines Audiogeräts gemäß einem der vorhergehenden Ansprüche, umfassend
die Herstellung eines Gehäuses (11),
das Vorsehen eines ersten Schutzschildes (20) und
das elastische Verbinden des ersten Schutzschildes mit dem Gehäuse.

## Revendications

1. Équipement audiophonique, comprenant :
un boîtier (11) ; et
les composants d'un circuit audiophonique (44), installés à l'intérieur du boîtier ;
**caractérisé en ce qu'**un écran protecteur (20) est relié de façon flexible au boîtier.

2. Équipement audiophonique selon la revendication 1, dans lequel l'écran protecteur se présente sous la forme d'une barre (20).

3. Équipement audiophonique selon la revendication 1 ou la revendication 2, comprenant en outre une poignée (21), fixée à l'écran protecteur.

4. Équipement audiophonique selon l'une quelconque des revendications 1 à 3, comprenant en outre un ensemble connecteur (30), reliant de façon flexible l'écran protecteur au boîtier.

5. Équipement audiophonique selon la revendication 4, dans lequel l'ensemble connecteur comprend un joint flexible (31).

6. Équipement audiophonique selon la revendication 4 ou la revendication 5, dans lequel l'ensemble connecteur est disposé entre l'écran protecteur et le boîtier.

7. Équipement audiophonique selon l'une quelconque des revendications 1 à 6, comprenant en outre un deuxième écran protecteur, relié de façon flexible au boîtier.

8. Équipement audiophonique selon la revendication 7, dans lequel les écrans protecteurs sont composés de deux barres (20), formées en boucles respectives et reliées à un côté respectif du boîtier.

9. Équipement audiophonique selon la revendication 8, possédant un écran protecteur comprenant en outre une poignée (21), fixée rigidement sur les barres (20).

10. Équipement audiophonique selon l'une quelconque des revendications précédentes, comprenant en outre :
une alimentation électrique (40) ;
un chargeur de groupe de batterie (43), relié à l'alimentation électrique ;
un circuit (44) pour produire un signal audio, de préférence un circuit radio, relié â l'alimentation électrique ; et
un groupe de batteries (60), pour utilisation avec un outil motorisé, le groupe de batteries étant relié de façon amovible au chargeur de groupe de batteries, pour se charger.

11. Équipement audiophonique selon l'une quelconque des revendications précédentes, comprenant en plus un ensemble de réceptacle (50) pour recevoir une batterie reliée de façon flexible au boîtier principal.

12. Équipement audiophonique selon la revendication 11, dans lequel l'ensemble de réceptacle comprend un boîtier de réceptacle (55), et un joint flexible (51), de préférence réalisé en caoutchouc ou en élastomère, est disposé entre le boîtier de réceptacle et le boîtier principal.

13. Équipement audiophonique selon la revendication 12, dans lequel l'ensemble de réceptacle comprend en outre au moins un élément de retenue (52), disposé sur le boîtier pour empêcher tout détachement du joint.

14. Équipement audiophonique selon l'une quelconque des revendications 11 à 13, comprenant en outre une porte (19), reliée de façon articulée au boîtier principal et placée à l'opposé de l'ensemble de réceptacle.

15. Équipement audiophonique selon la revendication 14, dans lequel la porte possède un ressort (54) disposé sur elle, pour solliciter une batterie, disposée dans l'ensemble de réceptacle, à aller vers une position de connexion.

16. Équipement audiophonique selon l'une quelconque des revendications précédentes, dans lequel le circuit audio est un circuit radio.

17. Équipement audiophonique selon l'une quelconque des revendications précédentes, comprenant :
un chargeur (43), disposé à l'intérieur du boîtier ;
un réceptacle (50), réalisé dans le chargeur ;
un groupe de batteries (60), susceptible d'être connecté de façon désolidarisable dans un outil motorisé monté dans le réceptacle ;
un premier circuit électrique dans le chargeur, afin de charger le groupe de batteries et d'alimenter électriquement le circuit audio ; et
un connecteur, pour assurer la connexion du premier circuit électrique à une source électrique.

18. Équipement audiophonique selon la revendication 17, dans lequel le connecteur est adapté pour la connexion à une source d'énergie en courant alternatif AC et l'équipement comprend en outre un deuxième circuit électrique susceptible d'être relié au groupe de batteries pour alimenter le circuit audio lorsque le connecteur est déconnecté d'une source d'énergie en courant alternatif AC.

19. Un procédé de fabrication d'un équipement audio tel que revendiqué dans l'une quelconque des revendications précédentes, comprenant :
la fabrication d'un boîtier (11) ;
la fourniture d'un premier écran protecteur (20) ;
la connexion flexible du premier écran protecteur au boîtier.
